# EUROPEAN PATENT APPLICATION

(11) **EP 2 509 115 A1**
(43) Date of publication of application: **10.10.2012**
(21) Application number: 11003055.8
(22) Date of filing: 12.04.2011
(51) Int. Cl.: H01L 31/048, B32B 27/32

(54) **Photovoltaic modules comprising a mainly TPO based adhesive integrated backsheet and a front encapsulant film with excellent adhesion to the glass front sheet**

(30) Priority: 08.04.2011 EP 11002947
(71) Applicant: RENOLIT Belgium N.V., 9700 Oudenaarde (BE)
(72) Inventor: RUMMENS, Francois, 1082 BRUXELLES (BE)
(74) Representative: Wagner, Jutta

(57) **Abstract**

The present invention describes an adapted front encapsulant (2) avoiding poor adhesion at the edges and corners of PV modules comprising a glass plate front layer (1) and a mainly TPO based adhesive integrated backsheet (10). The front encapsulant (2) is equipped with a face or layer (21) on base of grafted silane (co-) polyethylene, where the grafting reaction occurs before lamination.

## Description

### FIELD OF THE INVENTION

The present invention relates to photovoltaic (PV) modules comprising a glass plate top layer (1), an adapted transparent upper adhesive layer (also called front encapsulant film) (2), PV cells (4) and a mainly TPO based backsheet with integrated adhesive (10).

The front encapsulant film (2) is provided with a face or a coextruded layer (21), coming into direct contact with the glass plate top layer (1), which is on base of grafted silane (co)-polyolefin, where the grafting process has occurred before lamination.

By this, the adhesion of the encapsulant film (2) with the edges and corners of the PV module glass plate top layer (1) is much improved.

### BACKGROUND OF THE INVENTION

Within the scope of this invention, a photovoltaic module (also abbreviated PV module) comprises at least the following layers:
- a glass plate top layer (1),
- an adapted upper adhesive layer (2), connecting the top layer (1) and active layers (4),
- an active layer consisting at least of a photovoltaic material (4) sandwiched between a front and a back electrode layer
- a mainly TPO based backsheet (10) with integrated adhesive.

Such backsheet (10) is described in patent applications PCT/EP 2010/004335 ("Photovoltaic modules with Polypropylene based backsheet") and in European patent application N°: 10007553.0 ("Photovoltaic Modules using an adhesive integrated Heat Resistant multi-layer Backsheet").

An usual transparent upper adhesive layer (2) is most generally a 0,46 mm thick film based on peroxide crosslinkable EVA (ethylene vinyl acetate), with a high fluidity (Melt Index (g/10m; 190°C; 2,16 kg) of more than 40) and comprising free silanes (i.e. not grafted before the lamination step of the PV modules). Useful EVA films formulation are e.g. described in. WO 99/27588. They are well established as durable highly transparent adhesive layers. They are very useful to encapsulate thick crystalline Si PV cells (typically 250 µm) thanks to their ability to flow around the cells.

When using such adhesive films (2) to produce PV modules comprising a glass plate top layer (1), and a mainly TPO based backsheet (10) with integrated adhesive, one observes a lack of adhesion of the front encapsulant (2) to the glass plate top layer (1) at its edges and especially at its corners.

The reason for this lack of adhesion is linked to the high tendency to lateral flow of the EVA film (2) and of the mainly TPO based adhesive integrated backsheets (10) at typical lamination temperature (140 à 150 ... °C), under typical lamination pressure (between 0,5 and 1 bar). Under such pressure and temperature, the mainly TPO based adhesive integrated backsheet (10) flows laterally and the EVA adhesive (2) is expelled (30-40) and ripped (40) from the glass plate (1) at the edges/comers of the PV module. The initially free silanes of the EVA adhesive film (2) are indeed still un-sufficiently grafted to the EVA macromolecules to resist debonding at glass edges and comers: the lateral flow destroys the native connection between glass and EVA.

Further, when peroxide crosslinked EVA as front encapsulant (2) is combined with mainly TPO adhesive integrated backsheets (10), the peroxides of the EVA react with the TPO and its anti-oxydants leading to severe yellowing in climatic tests.

It is the object of the present invention to solve such problems and particularly the problem of poor adhesion between glass (1) and front encapsulant (2) at the corners and edges of PV modules, when mainly TPO adhesive integrated backsheets (10) are used.

### SUMMARY OF THE INVENTION

To solve the object of the invention, one provides a front encapsulant layer (2) comprising:
- a surface or a coextruded layer (21), coming in direct contact with the glass top layer (1), on base of a grafted silane functionalized (co-)polyethylene, where the silane is grafted to the (co)-polyethylene before lamination
- a core layer (22) on base of preferably cross-linkable (UV, silane, EBC, ...) (co-)polyethylene
- a surface or a coextruded layer (23), coming into direct contact with the PV cells (4) on base of functionalized (co-)polyethylene, selected to achieve optimal adhesion to the front contact of the PV cells (4).

Because the silanes are grafted before the lamination step to the (co-) polyethylene, the adhesion with glass is not destroyed by the lateral flow of the front encapsulant (2) and backsheet (10) during lamination of the PV modules.

A functionalized (co-)polyethylene is a (co-)polyethylene grafted or copolymerized with reactive groups, like silanes, acrylic acids, methacrylic acids, maleic anhydride, glycidyl methacrylate, hydroxyalkylacrylate and possibly copolymerized with polar comonomers chosen from vinyl acetate (VAc), acrylic ester (methylacrylate, ethylacrylate, butylacrylate, ethylhexylacrylate), etc.

Soft (co-)polyethylene are preferred and selected by the man skilled in the art to achieve high transparency. Metallocene very low density polyethylene (with e.g. octene comonomers) or EVA are preferred (co-)polyethylene.

To limit the lateral flow during lamination, (co-)polyethylenes with a Melt Index (g/10m; 190°C; 2,16 kg) of lower than 30, especially of lower than 10, are preferred.

### DETAILED DESCRIPTION OF THE INVENTION

"Mainly TPO adhesive integrated backsheets (10)" used for this invention are described in patent applications PCT/EP 2010/004335 ("Photovoltaic modules with Polypropylene based backsheet"), the text of which is incorporated by reference
and in European patent application N°: 10007553.0 ("Photovoltaic Modules using an adhesive integrated Heat Resistant multi-layer Backsheet"), the text of which is incorporated by reference, and comprise:
i. a tie-layer (13b) in contact with the backside (electrical back-contact, ...) of the PV cells (4), on base of a functionalized (e.g. by grafting or copolymerizing a functional group like a silane or a maleïc anhydride or an acrylic acid, or a glycidyl methacrylate, ...) co-polyethylene, such functional group selected to achieve a good adhesion to the backside (electrical back-contact, ...) of the PV cells (4).
ii. possibly a preferably soft (co-)polyethylene based layer (12a) selected (softness, melt index, thickness) to achieve a good encapsulation of e.g. thick crystalline silicon cells. The thickness and fluidity will be increased in case of thick PV cells. The softness may be increased to limit mechanical damages to the PV cells (4).
iii. One or more connecting layers (12b, 12c, 12d ...) allowing achieving good adhesion between the co-polyethylene based layer(s) (13b, 12a) and the (F)PP layer(s) (11)
iv. a (Flexible) PolyPropylene layer (11), being preferably a multi-layers layer comprising at least one layer with higher heat resistance to keep mechanical integrity during lamination temperature.
The Connecting layers can be:
- option 1) a TPO mixture based layers or layer creating an interpenetrated network of VLDPE and PP (based e.g. on a mixture of VLDPE, FPP reactor blend and PP elastomer). Such layers may be partly crosslinked to improve inter-layers adhesion
- option 2) a 3-layer reactive system, being "a PE-g-MAH based layer / a PA based film layer or an EVOH based film layer/ a PP-g-MAH based layer".
- option 3) a 2-layer reactive system, being "a PE-GMA copolymer based layer / a PP-g-MAH based layer". See for more details US 2010/0108128 A1 (coextruded, multilayered polyolefin-based backsheet for electronic device modules)).

The surface or coextruded layer (21), coming into direct contact with the glass top layer (1) is on base of a, before the lamination step of the PV modules, grafted silane functionalized (co-)polyethylene.

Such grafted silane functionalized (co-)polyethylene can be achieved by reactive extrusion as described in:
"crosslinking of LLDPE and VLDPE via graft-polymerized vinyltrimethoxysilane, Stefan Ultsch and Hanz-Gerhard Fritz, Plastics and Rubber Processing and Applications 13 (1990;81 - 91)",
the text of which is incorporated by reference.

A very useful silane for this invention is also Gamma-Methacryloxypropyl trimethoxysilane (silane Z6030 from Dow Coming). Preferred grafted silane concentration are between 0,5 and 5 % weight, most preferably between 1,5 and 3 %.

Grafting of silanes can also be achieved by e.g. plasma techniques or by photoinitiators under UV light.

The core layer (22) is preferably on base of cross-linkable (UV, silane, EBC, peroxide ...) (co-)polyethylene

The surface or coextruded layer (23), coming into direct contact with the PV cells (4) is on base of functionalized (co-)polyethylene selected to achieve optimal adhesion to the front contact of the PV cells (4) and may be cross-linkable.

Useful (co)-polyethylene are e.g. ethylene/alpha-olefin interpolymers and are described in WO 2008/036708 A2 or are EVA copolymers (Polyethylene co Vinyl Acetate) or Polyethylene co Acrylate (like butyl acrylate, etc.) or EVA rubber (Levamelt ® from Lanxess),

Useful stabilization of such (co)-polyethylene is also described in WO 2008/036708 A2.

Acid scavengers, nucleating agent, ... are useful additives.

The upper adhesive film (2) is preferably produced by (co-)extrusion according to the teaching of e.g. WO 2008/036708 A2 (the text of which is incorporated by reference) and US 2010/0069538 A1: (olefin compositions with enhanced adhesion and light stability - the text of which is incorporated by reference).

UV crosslinking can be achieved by incorporation into the formulation of the layers of upper adhesive film (2), especially core layer (22) of photoinitiators like Benzophenone and crosslinkers like TAIC, according to the teaching of:
Photoinitiated crosslinking of ethylene-vinyl acetate copolymers and characterization of related properties
Polymer Engineering & Science 47/11,1761-1767 11/2007
Yao, Dahong; Qu, Baojun: Wu, Qianghua
the text of which is incorporated by reference

To improve compatibility with apolar polymer like metallocene octene co-polyethylene, the benzophenone can be chemically modified and provided with an alkyl chain like in di(4-hydroxyl benzophenone) sebacate

To limit lateral flow, the layers of the front encapsulant (2) and especially the core layer have a low Melt Index and/or are preferably partly cross-linked before lamination (before pressure is applied), such as a Melt Index (Melt Index - g/10m; 190°C; 2,16 kg) of less than 30, preferably less than 10, most preferably less than 5 of the layers is achieved when the lamination pressure is applied.

The invention is also useful for other backsheets, particularly EPDM based backsheet like described in PCT/US2008/0078444.

Grafting silanes, before lamination, to the front encapsulant (2) -especially layer (21) - is also useful to avoid or delay delamination as a result of aging, particularly in humid conditions, of front encapsulant (2) from the front layer (1) of PV modules in particular at its edges and corners. Classical PV modules (glass (1) / peroxide cured EVA (2) / PV cells (4) / EVA / classical backsheet like Tedlar ®/PET/Tedlar ®) will therefore also benefit from the invention.

The invention will be illustrated further by reference to the attached drawings which are not meant to restrict the scope to the specific embodiments shown. Other combinations of the preferred features than those shown are also possible and advantageous. It should be appreciated that for simplicity and clarity of illustration, elements shown in the figures have not necessarily be drawn to scale.

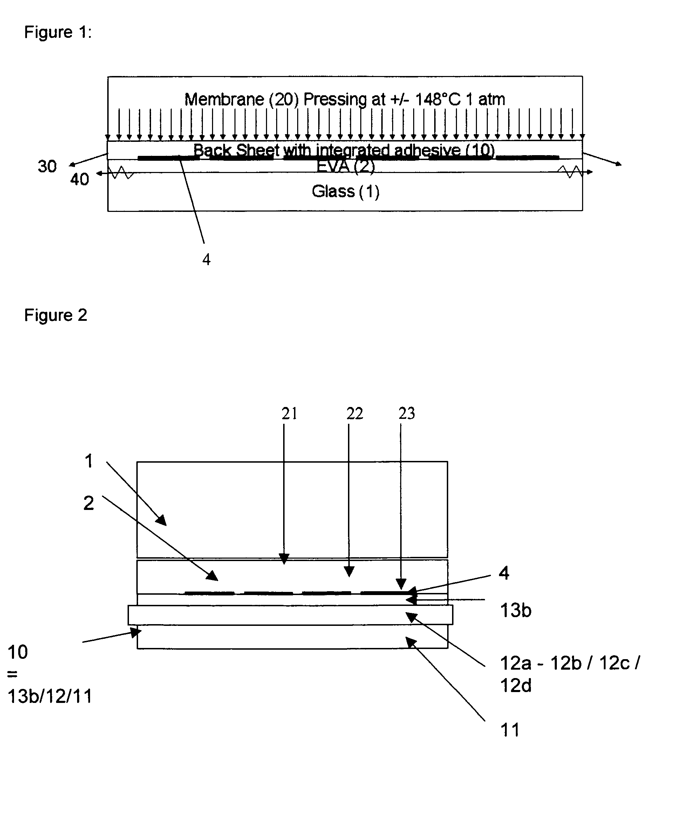

Figure 1 shows a cross section of a PV module being laminated in a classical membrane (20) press:

The cross-section shows:
- a glass plate (typically a 3,2 mm low iron tempered glass) (1)
- a EVA front encapsulant (2), e.g. a film of EVA Vistasolar 486.10 - 0,46 mm.
- PV cells (4)
- An adhesive integrated backsheet (10)
- A membrane (20) pressing the several layers (1, 2, 4, 10) together at a temperature of +/- 145°C, with a pressure between 0,5 and 1 bar, and leading to lateral flow (se arrows 30) of the backsheet (10) and mainly of the EVA layer (2), with as result poor adhesion (40) between glass (1) and EVA (2): Under such pressure and temperature, the EVA adhesive (2) is expelled (30-40) and ripped (40) from the glass plate (1) at the edges and corners of the PV module.

Figure 2 shows a cross section of a PV module with:
i. A top layer glass plate (1)
ii. A transparent upper adhesive layer (2) according to the present invention, with possible sub-layers:
   1. (21) layer or surface in contact with the glass plate
   2. (22) core layer
   3. (23) layer or surface in contact with the PV cells (4).
iii. Active layers (4)
iv. A mainly TPO based backsheet with integrated adhesive (10) comprising:
   1. a functional (co-)PE tie-layer (13b) with good adhesion to active layers (4) back-electrode or back barrier or back primer coating and to adhesive layer (2),
   2. If desired, a possibly multi-layer encapsulating layer (12a), having appropriate softness to limit stresses on active layer(s) (4), adequate viscosity and thickness to encapsulate possibly thick active layer(s) like crystalline silicone PV cells (4).
   3. If required connecting layers (12b) (12c) (12d) ...
   4. A backsheet (11) e.g. based on a multi-layer (F)PP based layer.

EXAMPLES and BEST MODE of the INVENTION

The invention will be further clarified by the following examples which are not meant to restrict the scope to the specific provided examples. Other combinations of the preferred featues than those shown are also possible and useful.

Example 1):

One produces by extrusion a 0,46 mm front encapsulant mono-layer film (2) with following formulation, adapted from WO 2008/036708 (example 4)

| Ingredient | Weight Percent |
|---|---|
| Engage 8200 | 97,32 |
| Cyasorb 2908 | 0,15 |
| Cyasorb UV 3853 | 0,15 |
| Lowilite 19 | 0,2 |
| Weston 705 | 0,1 |
| Silane Z 6030 Dow Corning (MEMO) | 2 |
| Luperox 101 (DHBP peroxide) | 0,08 |
| Total | 100 |

| | |
|---|---|
| Engage 8200 is an ethylene-octene copolymer, with a Melt Index, g/10 min (2.16 kg @ 190°C - ASTM D 1238) of 5 | |

One produces a mainly TPO based adhesive integrated backsheet (10) as follows:
By coextrusion/lamination one produces, around 250°C (extrusion temperature), the following multi-layer film (10):
   - Tie-Layer (13b), entering into direct contact with the PV cells (4) = a 50 µm thick layer on base of LLDPE-MAH grafted like Orevac 18300 from Arkema,
   - Encapsulating Layer (12a) = 300 µm thick layer on base of a mixture 70/30 Exact 0201 (a VLDPE resin from Dexplastomer) and Infuse 9100 (a OBC resin from Dow).
   - Several 50 µm thick connecting layers (12b,12c, 12d) on base of mixtures of Hifax CA 10 A, Hifax CA 60, Hifax CA 02, VLDPE and Elastomer PP, progressively matching the composition of layers (12a) and (11), to be connected together.
   - FPP layers (11) being a multi-layers layer:
      - (11a) A 200 µm layer in contact with layer 5 (12d), on base of Hifax CA 10 A, Hifax CA 60 and Hifax CA 02.
      - (11b) A 50 µm central layer on base of a homopolymer PP impact modified
      - (11c) A 50 µm rear layer on base of Hifax CA 10 A and Hifax CA 60

One produces in a classical vacuum laminator under 1 bar at 145°C the following dummy PV module (conditions in following table):
- 3,2 mm glass plate (1)
- The front encapsulant (2) of example 1.
- Interconnected crystalline silicon PV cells (250 µm thick)
- The back sheet (10) of example 1.

After cooling of the produced dummy module, one tries to initiate a delamination of the encapsulant from the glass plate at the corners of the dummy PV module, without success.

**Table:**

| Step | T(°C) | Time | Pressure Under (mbar) | pressure above (mbar) |
|---|---|---|---|---|
| Vacuum pins up | 145 | 3' | 0 | 0 |
| Vacuum pins | 145 | 4' | 0 | 0 |
| down | | | | |
| pressing ramp | 145 | 90 sec | 0 | 1000 |
| Curing | 145 | 10' | 0 | 1000 |
| Venting | 145 | 20 sec | Atm | Atm |
| Open | 145 | 20 sec | Atm | Atm |

Counter-Example 1):
As in example 1, but the front encapsulant (2) is replaced by EVA Etimex Vistasolar 486.10.
After cooling of the produced dummy module, one tries to initiate a delamination of the encapsulant (2) from the glass plate (1) at the corners of the dummy PV module. Poor adhesion (delamination on typically 1cm) is obtained at the corners of the dummy PV module. Visually, a lack of EVA (2) is observed at the corners.

Example 2):

One produces by coextrusion a 0,46 mm front encapsulant tri-layer film (2) with following formulation:
i. Layer 21: a 50 µm thick layer with the same composition as film (2) of example 1) but with engage 8200 replaced by Escorene Ultra FL 00328
ii. Layer 22 on base of a UV crosslinkable EVA composition comprising usual UV photoinitiators (e.g. 1 % Benzophenone) and crosslinkers (e.g. 1 % TAIC).
iii. Layer 23: as layer 21

Escorene Ultra FL 00328 is an ethylene-VinylAcetate copolymer (EVA; 28 % VAc), with a Melt Index, g/10 min (2.16 kg @ 190°C - ASTM D 1238) of 3

One produces the "mainly TPO based adhesive integrated backsheet (10)" as follows:
By coextrusion/lamination one produces, around 250°C (extrusion temperature), the following multi-layer film (10):
   - Tie-Layer (13b), coming into direct contact with the PV cells (4) = a 50 µm thick layer on base of plexar PX1007 (a EVA-MAH grafted copolymer from MSI Technology)
   - Other layers like example 1, but the layer (12a) comprises preferably acid scavengers especially acetic acid scavengers like e.g. Mg(OH)2.

One produces in a classical vacuum laminator under 1 bar at 145°C the following dummy PV module:
- 3,2 mm glass plate (1)
- The front encapsulant (2) of example 2.
- Interconnected crystalline silicon PV cells (250 µm thick)
- The back sheet (10) of example 2.

After UV crosslinking (at the exit of the laminator under iron doped Hg lamps - D bulb) and cooling of the produced dummy module, one tries to initiate a delamination of the encapsulant from the glass plate at the corners of the dummy PV module, without success.

Counter-Example 2):
As in example 2, but the front encapsulant (2) is replaced by a 0,46mm thick UV curable EVA composition comprising silanes (not grafted) and usual UV photoinitiators and crosslinkers (like for core layer (22) of example 2).
After UV crosslinking and cooling of the produced dummy module, one tries to initiate a delamination of the encapsulant from the glass plate at the corners of the dummy PV module. Poor adhesion (delamination on typically 1cm) is observed at the corners of the dummy PV module.

As will be apparent the foregoing description does not cover all possible combinations. Other combinations may be derived by the man skilled in the art from the present description and are useful.

List of reference numbers
- 1: glass plate top layer
- 2: upper adhesive layer
- 21: face or coextruded layer, coming into direct contact with (1)
- 22: core layer(s)
- 23: face or coextruded layer, coming into direct contact with (4)
- 4: photovoltaic cells, active material
- 10: Backsheet
- 11: (F)PP layer
- 12b: Connecting layers
- 12a: Encapsulating layer(s)
- 13b: PE based tie-layer in direct contact with the PV cells (4)
- 20: Membrane of the vacuum laminator

## Claims

1. A PV module comprising:
- a glass plate (1)
- a front encapsulant (2)
- PV cells (4)
- a mainly TPO based backsheet with integrated adhesive (10),
where the front encapsulant (2) comprises a face or a coextruded layer (21) on base of a grafted silane functionalized (co-)polyethylene, where at least 0,5% weight of silane is grafted to the (co)-polyethylene before lamination pressure.
